# EUROPÄISCHE PATENTSCHRIFT

(11) **EP 0 494 656 B1**
(45) Veröffentlichungstag und Bekanntmachung des Hinweises auf die Patenterteilung: **28.05.1997**
(21) Anmeldenummer: 92100200.2
(22) Anmeldetag: 08.01.1992
(51) Int. Cl.: G01R 31/11

(54) **Schaltungsanordung zur Ortung hochohmiger und intermittierender Kabelfehler**
Circuit arrangement for locating high ohmic and intermittent cable faults
Arrangement de circuit pour localiser des défauts de câble à haute résistance ohmique et intermittents

(30) Priorität: 08.01.1991 DE 4100305
(43) Veröffentlichungstag der Anmeldung: 15.07.1992
(73) Patentinhaber: Seba-Dynatronic Mess- und Ortungstechnik GmbH, D-96148 Baunach (DE)
(72) Erfinder: Kreutzer, Martin, Dr.-Ing., W-8619 Zapfendorf (DE)
(74) Vertreter: Riebling, Peter, Dr.-Ing., Patentanwalt

(56) Entgegenhaltungen:
- EP-A- 0 402 566
- DE-A- 2 062 714
- DE-A- 2 945 267
- DE-A- 3 707 171
- DE-A- 3 711 593
- DE-A- 3 805 733

## Beschreibung

Die Erfindung betrifft eine Schaltungsanordnung zur Vorortung hochohmiger und intermittierender Kabelfehler unter Anwendung der Impuls-Echo-Methode nach dem Oberbegriff des Patentanspruchs 1.

Mit dem Impuls-Echo-Verfahren können im allgemeinen Kabelfehler geortet werden, deren Impedanz nicht größer ist als etwa der zwanzigfache Wellenwiderstand Z0 des Kabels. Die Schaltungsanordnung zur Ortung der Kabelfehler wird im wesentlichen dazu eingesetzt, um einen Lichtbogen an der fehlerhaften Stelle im Kabel zu erzeugen, wobei gleichzeitig eine Reduzierung der Impedanz am Ort des Kabelfehlers ZF << 20·Z0 erreicht wird. Diese temporäre Reduktion der Impedanz an der Fehlerstelle im Kabel wird demnach durch die Erzeugung des Lichtbogens an der Fehlerstelle erreicht, wobei der Lichtbogen für die Zeit der Messung aufrechterhalten werden muß. Im allgemeinen muß der Lichtbogen nur für wenige Millisekunden aufrechterhalten werden, um störungsfrei die Echo-Messung durchführen zu können.

Das Vorgehen in Verbindung mit der Schaltungsanordnung zur Erzeugung des Lichtbogens an der Fehlerstelle im Kabel muß deshalb folgende Aufgaben beinhalten:
A) Zündung des Lichtbogens am Ort des Fehlers im Kabel
B) Aufrechterhaltung des Lichtbogens während der Messung
C) Ankopplung des Impuls-Echo-Meßgerätes an das Kabel, wobei gleichzeitig die vor- und rücklaufenden Meßimpulse von der Energiequelle entkoppelt sind.

Eine Schaltungsanordnung zur Ortung hochohmiger und intermittierender Kabelfehler ist bereits aus der DE-A-37 07 171 des Anmelders, von welcher im Oberbegriff des Anspruchs 1 ausgegangen wird, bekannt. Es werden bereits zwei getrennte Gleichspannungsquellen verwendet, wobei eine erste Gleichspannungsquelle hoher Ausgangsspannung kurzfristig zur Zündung des Lichtbogens dient und eine zweite Gleichspannungsquelle niedrigerer Ausgangsspannung zur Aufrechterhaltung der Brenndauer des Lichtbogens verwendet wird. Die Brenndauer des Lichtbogens liegt bei dieser bekannten Schaltungsanordnung im Sekundenbereich, was jedoch bei manchen Kabelfehlern nicht immer wünschenswert ist.

Aus der DE-A-38 05 733 ist ein Prüfgenerator bekannt geworden, bei welchem in den Pfad zwischen der Spannungsquelle des Prüfgenerators und dem zu prüfenden Kabel ein spannungsabhängiges Element geschaltet ist. Das spannungsabhängige Element weist eine Ansprechspannung auf, die so gewählt ist, daß das spannungsabhängige Element bis zu einer maximal zulässigen Prüfspannung an der Prüfkapazität hochohmig ist und über dieser maximal zulässigen Prüfspannung niederohmig ist.

Eine weitere Schaltungsanordnung zur Ortung von Kabelfehlern ist aus der DE-C-30 32 519 bekannt, wobei dort eine sehr kurze Meßdauer an der Fehlerstelle im Kabel erzielt wird. Allerdings verwendet diese bekannte Schaltungsanordnung eine Induktivität im Schaltkreis der Zündspannung, wobei auch Stoßwellengeneratoren Verwendung finden. Eine derartige im Zündstromkreis verwendete Induktivität weist aber Nachteile auf. So glättet zwar die Induktivität die Zündspannung in gewissen Bereichen, was jedoch gleichzeitig mit einer ganz erheblichen Verringerung des Scheitelwertes der vom Stoßwellengenerator auslaufenden Ur-Zündspannungswelle selbst verbunden ist, so daß vielfach Kabelfehler in realen verlustbehafteten Kabeln nicht geortet werden können.

Insbesondere gilt dies für lange und/oder nasse Kabel, da hier ein nachfolgender Spannungsaufbau auf dem Kabel durch Mehrfachreflexion, in der Regel nicht mehr, oder nur sehr eingeschränkt, möglich ist. Außerdem ist eine derartige Induktivität relativ teuer und baulich relativ groß und schwer ausgebildet, so daß sich dadurch ebenfalls Nachteile ergeben.

Bei der Verwendung einer Induktivität im Zündstromkreis liegt auch der weitere Nachteil vor, daß eine Entkopplung der erreichten Zündspannung von der erforderlichen Stromflußzeit für die Impuls-Echo-Messung nicht gegeben ist. Bei entsprechend ausreichend großer Induktivität ist die Stromflußdauer zwar ausreichend, die erreichbare Zündspannung der auslaufenden Urwelle aber auf wenige Zehntel des am Stoßwellengenerator eingestellten Wertes begrenzt. Bei entsprechend kleiner Induktivität besteht die Einschränkung in einer für die Messung viel zu kurzen Stromflußdauer.

Die Induktivität verlängert zwar die Stromflußzeit der Stoßwelle, jedoch überwiegen die Nachteile, insbesondere weil Spitzenspannungen, die sonst zur Ortung besonders schwer erreichbarer Kabelfehler dienen könnten, nicht mehr erreicht werden.

Eine Schaltungsanordnung zur Ortung von Kabelfehlern mit einer Induktivität liegt auch der EP-A-148 674 zugrunde, wobei dort aber die oben angegebenen Verhältnisse zutreffen, das heißt bei besonderer Ausgestaltung von Kabelfehlern, wie diese auch bei nassen Kabeln vorliegen können, und stets bei entsprechend langen Kabeln vorliegen, wird eine einwandfreie Fehlerortung oftmals nicht erreicht.

Aufgabe der vorliegenden Erfindung ist es deshalb, eine Schaltungsanordnung der eingangs genannten Art zur Ortung hochohmiger und intermittierender Kabelfehler so weiterzubilden, daß auch sonst schwer ortbare Kabelfehler, insbesondere in nassen und langen Kabeln, leicht geortet werden können, wobei eine kurze Brennzeit im Bereich von Millisekunden, des Lichtbogens angewendet wird und hierbei in technisch einfacher und ökonomisch sinnvoller Art eine Schaltungsanordnung geschaffen wird.

Zur Lösung der Aufgabe sind die Merkmale des kennzeichnenden Teils des Patentanspruchs 1 vorgesehen.

Das Wesen der Erfindung liegt im wesentlichen darin, daß die Stoßwelle praktisch über einen nur sehr geringen, vernachlässigbar kleinen Vorwiderstand läuft, während die Meßimpulse innerhalb von Mikrosekunden nach dem Stoß vom Stoßwellengenerator entkoppelt werden. Die vorliegende Erfindung ist demnach darin begründet, daß als Zündelement ein zunächst bekannter Stoßwellengenerator verwendet wird, wobei in Verbindung mit der Nichtlinearität, ausgehend von deren Schaltschwelle die Energie des Stoßwellengenerators voll zur Zündung des Lichtbogens ausgenützt werden kann. Im Zündkreis des Stoßwellengenerators liegt lediglich ein vernachlässigbarer, kleiner ohmscher Widerstand, im Bereich von einigen Ohm, der zur Entkopplung zusätzlich dient und im übrigen Störungen des Stoßwellengenerators unterdrückt. Damit ist es nun erstmals möglich, einen Stoßwellengenerator bei der Impuls-Echo-Messung am Lichtbogen so einzusetzen, daß dessen volle Energie im wesentlichen allein für die Zündung des Lichtbogens an der Fehlerstelle zur Verfügung steht, wobei Kabelfehler nun erkannt werden können, die sonst nicht ohne weiteres erkennbar waren.

Beim Stand der Technik wurden die Eigenschaften der an sich bekannten Stoßwellengeneratoren dadurch beeinträchtigt, daß als Ankoppelelement eine Induktivität bzw. Drossel oder auch ein hochdimensionierter Widerstand zur Verlängerung des Zündimpulses verwendet werden mußte, wodurch ein Spannungsverlust in Kauf genommen werden mußte. Bei der Erfindung jedoch können praktisch auch schwierige Fehler im Kabel gezündet werden, die anschließend in Verbindung mit der weiteren Spannungsquelle welche den Lichtbogen aufrechterhält, mittels des ankoppelbaren Impuls-Echo-Meßgerätes erkannt werden.

Der Zündstrom der Zündspannungsquelle durchläuft demnach in Richtung zum Kabelfehler das nichtlineare Element N₀, wobei dieses praktisch wie ein Kurzschluß wirkt. Unmittelbar danach sperrt das nichtlineare Element in Verbindung mit einer sehr kurzen Schaltzeit, die abhängig von dem verwendeten nichtlinearen Element ist. Hierdurch werden die vor- und rücklaufenden Meßimpulse des Impuls-Echo-Meßgerätes entkoppelt.

In bevorzugter Ausgestaltung des nichtlinearen Elementes können ein Varistor, eine Luftfunkenstrecke oder eine Gasfunkenstrecke eingesetzt werden. Bei diesen Elementen ist es in besonders guter Ausbildung vorgesehen, daß beim Anlegen einer entsprechend hohen Spannung ein Durchgang erreicht wird, während beim Anlegen einer entsprechend niedrigen Spannung, eine Sperrung des Elementes aufgebaut ist.

Weiterhin können als Nichtlinearität im Zündstromkreis zur Zündung des Kabelfehlers auch weitere Nichtlinearitäten eingesetzt werden, wie zum Beispiel eine Induktivität, die sich im Augenblick der Zündung im Sättigungszustand befindet, oder die Primär- oder Sekundärwicklung eines Transformators, wobei sich diese Wicklungen ebenfalls im Sättigungszustand befinden, insbesondere durch das Anlegen einer Gleichspannung an die jeweils andere Wicklung des Transformators.

Weiterhin können als Nichtlinearität auch ein Kaltleiter, oder eine Glühlampe, oder ein Überspannungsableiter, oder auch gesteuerte oder geregelte, zeitvariante lineare Elemente eingesetzt werden. Bei diesen Elementen ist es ebenfalls nach Art einer Sperre ausgebildet, daß die Zündspannung nahezu ungehindert passieren kann, während für die Meßimpulse ein erheblicher Widerstand ausgebildet ist.

Nach der Zündung des Fehlers im Kabel wird über die weitere Gleichspannungsquelle, deren Spannung wesentlich niedriger ist als die Spannung der Zündspannungsquelle, das Weiterbrennen des Lichtbogens durchgeführt. Im Zweig der weiteren Spannungsquelle zur Aufrechterhaltung des Lichtbogens ist hierzu eine Diode D angeordnet, welche die Zündspannungsquelle von der weiteren Spannungsquelle entkoppelt. Weiterhin ist im Schaltkreis der weiteren Spannungsquelle eine relativ kleine Induktivität und ein Vorwiderstand in Verbindung mit einem Ladekondensator C₁ vorgesehen, wodurch die Meßimpulse von der weiteren Spannungsquelle entkoppelt werden.

In weiterer Ausbildung ist es hierzu vorteilhaft vorgesehen, daß im Ankopplungszweig der weiteren Spannungsquelle U₁, an das Kabel ein Widerstand eingeschaltet ist, wobei in Verbindung mit der Ladekapazität die Entkopplungsdiode entfallen kann.

Bei entsprechender Dimensionierung des Widerstandes im Ankopplungszweig der weiteren Spannungsquelle kann auch die Induktivität entfallen.

Im weiteren ist es vorteilhaft vorgesehen, daß die niederohmige Impedanz im Ankopplungszweig des Stoßwellengenerators aus einem ohmschen Widerstand besteht, welchem in Parallelschaltung ein weiterer ohmscher Widerstand und ein Kondensator zugeordnet sind.

Diese niederohmige Impedanz im Ankopplungszweig des Stoßwellengenerators kann auch vorteilhaft aus einer Parallelschaltung eines ohmschen Widerstandes mit einen Kondensator bestehen.

Im folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: Eine Schaltungsanordnung zur Ortung von Kabelfehlern mit angekoppeltem Impuls-Echo-Meßgerät in Verbindung mit einer Nichtlinearität im Bereich des Stoßwellengenerators;
- Figur 2:: Die Ausführung eines Vorwiderstandes im Ankopplungszweig des Stoßwellengenerators;
- Figur 3:: Den Vorwiderstand nach Figur 2 in einer anderen Ausführung.

Nach Bild 1 ist ein Stoßwellengenerator mit einer Spannung U₀ vorgesehen, wobei in Verbindung mit einem Ladungswiderstand R₀ und einer Ladekapazität C₀ eine Stoßwelle an einer Luftfunkenstrecke ausgelöst wird. Diese Stoßwelle gelangt über den relativ kleinen, vernachlässigbaren Vorwiderstand R₂ und über die vorgeschaltete Nichtlinearität N₁ an das Kabel. Diese Nichtlinearität N₁ ist einer Ausgestaltung vorgesehen derart, daß die Stoßwelle praktisch unverändert auf die Fehlerstelle im Kabel gelangt, während, in Verbindung mit der Schaltschwelle der Nichtlinearität im Mikrosekundenbereich eine Sperrung vorliegt, wodurch die Meßimpulse des Impuls-Echo-Meßgerätes vom Stoßwellengenerator entkoppelt werden. Im Ankopplungszweig der weiteren Spannungsquelle U₁ ist zunächst eine Diode D vorgesehen, welche die Spannungsquelle U₁ von der Spannungsquelle U₀ entkoppelt. Im weiteren ist zusätzlich im Spannungszweig der weiteren Spannungsquelle U₁ noch eine relativ geringe Induktivität L ausgebildet, welche die Meßimpulse sperrt, so daß eine effektive Impuls-Echo-Messung am Kabel möglich ist.

Durch die Anschaltung der Nichtlinearität im Stoßstromkreis wird vorteilhaft die hohe Energie des Stoßwellengenerators praktisch vollständig für die Zündung des Fehlers ausgenutzt.

Durch den Überschlag an der Fehlerstelle, hervorgerufen durch die Stoßwelle in Verbindung mit der für Hochspannung sehr niederohmigen Nichtlinearität wird im Anschluß daran die zweite weitere Spannungsquelle U₁ angeregt, die eine sehr stark gedämpfte Stoßwelle auslöst, deren Energie zur Aufrechterhaltung des Lichtbogens nach dessen Zündung dient.

Die hierbei freiwerdende Energie aus dem Kondensator C₁ ist durch die Größe des Kondensators selbst, sowie durch die Ladespannung U₁ bestimmt und frei wählbar.

Im Schaltkreis der weiteren Spannungsquelle U₁ ist weiterhin ein Vorwiderstand R₃ ausgebildet, welcher der Glättung dient und zusätzlich auch eine Entkopplungsfunktion aufweist.

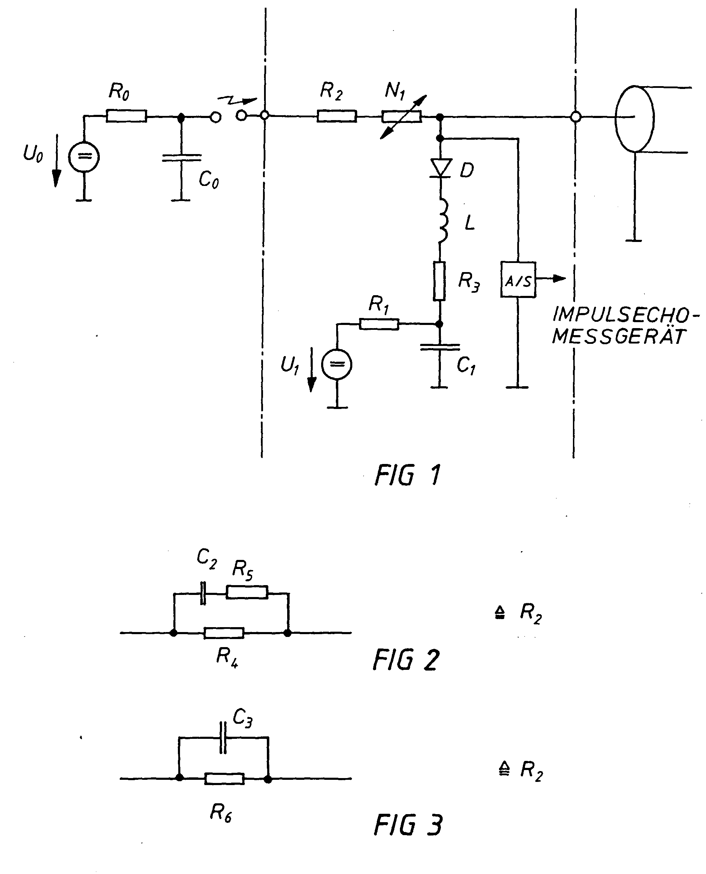

Der Widerstand R₂ kann nach den Figuren 2 und 3 ausgebildet sein und dient insbesondere einer geringfügigen Verlängerung der auslaufenden Stoßwelle zur Zündung des Kabelfehlers um einige Mikrosekunden. Der Widerstand R₂ gewährleistet damit die sichere Auslösung der zweiten Stoßwelle über die weitere Spannungsquelle U₁, ohne daß dabei die Zündeigenschaften wegen des relativ geringen Widerstandes R₂ wesentlich beeinflußt werden.

Nach der Zündung wird die Entkopplung der Echoimpulse vom Stoßwellengenerator durch das nichtlineare Element N₁ gewährleistet, wobei in nicht näherer Darstellung ein Varistor, eine Luftfunkenstrecke, oder Gasfunkenstrecke eingesetzt werden können. Im weiteren kann als Nichtlinearität N₁ auch eine Induktivität, die sich im Sättigungsbereich befindet, eingesetzt werden, oder in vergleichbarer Weise die Primär- oder Sekundärwicklung eines Transformators, dessen jeweils andere Wicklung durch eine Gleichspannung beaufschlagt ist, wodurch im Bereich der Zündung die Sättigung erreicht wird. Weiterhin kann als Nichtlinearität auch ein Kaltleiter, eine Glühlampe, oder ein Überspannungshalbleiter eingesetzt werden, oder gesteuerte oder geregelte zeitvariante lineare Elemente, die im Zeitpunkt der Zündung auf Durchlaß gesteuert sind, während einige Mikrosekunden später die Meßimpulse einen großen Widerstand vorfinden und damit entkoppelt sind.

In dieser Art ist der Zündvorgang von der notwendigen Aufrechterhaltung des Lichtbogenstromes nach der Zündung demnach vollständig entkoppelt. Das Impuls-Echo-Meßgerät wird mit Hilfe einer an sich bekannten Schaltung (A/S) hochspannungsmäßig entkoppelt und bezüglich der Meßimpulse an das Kabel angekoppelt und synchronisiert.

Die Entkopplung des Impuls-Echo-Meßgerätes von der Zündspannung U₀ des Stoßwellengenerators geschieht, gemäß der Regelkurve der Nichtlinearität N₁, wenige Mikrosekunden nach Auslösung der Stoßwelle. Wird die Nichtlinearität, zum Beispiel durch einen Varistor repräsentiert, so geht dieser nach Unterschreitung seiner entsprechend charakteristischen Spannung in Verbindung mit einer sehr kurzen Schaltzeit, nach einigen Mikrosekunden in den Sperrzustand über.

Der Stoßwellengenerator nach der vorliegenden Erfindung wird insoweit nur zur Erzeugung einer Stoßwelle verwendet, wobei deren Scheitelwert auf dem Kabel, durch die Verwendung des erfindungsgemäßen nichtlinearen Elementes N₁ und der relativ niederohmigen Widerstände R₀ und R₂ praktisch mit der Spannung U₀ nach Figur 1 identisch ist. Hierbei wird die sonst bekannte Anwendung einer Induktivität vermieden, welche zu einer drastischen Verringerung des Scheitelwertes der auslaufenden Stoßwelle führt. Hierdurch können sonst nicht zugängliche Kabelfehler geortet werden.

Die Zündeigenschaft des Stoßwellengenerators kann in Verbindung mit der Nichtlinearität wesentlich besser ausgenutzt werden, und es können wesentlich mehr Fehler entdeckt werden, da die gesamte Energie des Stoßwellengenerators für die Zündung zur Verfügung steht. Im übrigen braucht erfindungsgemäß die Stromflußdauer durch Energie aus dem Stoßwellengenerator nicht verlängert werden, weil die zusätzliche weitere Spannungsquelle U₁ ausgebildet ist, mit deren Hilfe das Weiterbrennen des Lichtbogens gesichert ist.

Der Widerstand R₂ im Stoßstromkreis dient zunächst einer geringfügigen Verlängerung der Stoßwelle und weist auch Eigenschaften von Siebwirkung zur Unterdrückung von Störungen auf. In Verbindung mit dem Widerstand R₂ verlängert die weitere Spannungsquelle U₁ die Stromflußdauer, um den Lichtbogen aufrecht zu erhalten. Die Zündeigenschaften der Spannungsquelle U₀ werden aber durch den Widerstand R₂ nicht wesentlich beeinflußt, da dieser Widerstand R₂ relativ klein ist, etwa in einer Größenordnung von einigen Ohm. Beim Stand der Technik wird ein derartiger Widerstand in der Größenordnung von einigen hundert Ohm verwendet, evtl. in Verbindung mit einer Induktivität. Dadurch ergeben sich beim Zünden schwer erreichbarer Kabelfehler Nachteile, so daß nicht alle Kabelfehler mit den bekannten Anordnungen gezündet werden können.

Der Widerstand R₂ kann auch durch eine RC-Schaltung ersetzt werden, wobei es wesentlich ist, daß zu einem ohmschen Widerstand R₄, der bei einigen Ohm liegt, eine Serienschaltung eines Kondensators C₂ mit einem Widerstand R₅ parallelgeschaltet wird. Stößt nun die Stoßwelle auf eine derartige RC-Anordnung dann wirkt zunächst dynamisch die Parallelschaltung der beiden Widerstände R₄ und R₅, weil der Kondensator C₂ praktisch für die Stoßwelle einen Kurzschluß bildet. Damit wird der Gesamtwiderstand der Anordnung im Stoßbereich verringert, wodurch die Stoßwelle nur noch einen ganz geringen ohmschen Widerstand im Ankopplungszweig zum Kabelfehler vorfindet.

Im weiteren Verlauf verflacht sich die Stoßwelle und der Kondensator C₂ wird, entsprechend seiner Ladezeit den Zweig mit dem Widerstand R₅ entkoppeln, und es liegt dann nur noch der größere Widerstand R₄ im Zweig vor. Damit ergibt sich der Vorteil, daß die Stoßwelle zunächst praktisch mit voller Energie auf das Kabel gegeben werden kann und daß dann aber, mit nachlassender Stoßwelle, eine Erhöhung des Widerstandes dieses Zweiges stattfindet und damit eine Verlängerung der Stromflußdauer auf einige Mikrosekunden stattfindet.

Der Widerstand R₂ kann auch durch eine Parallelschaltung eines Kondensators C₃ mit einem Widerstand R₆ ersetzt werden. Hier ist der Unterschied, daß der Kondensator C₃ im Augenblick der Stoßspitze einen Kurzschluß bildet und diese ungehindert durchläßt, während anschließend der Widerstand R₆ zur Wirkung kommt. Bei dieser Ausführungsform nach Figur 3 wird demnach, im Gegensatz zu Figur 2, auf eine Strombegrenzung, etwa durch den Widerstand R₅ nach Figur 2 völlig verzichtet.

## Patentansprüche

1. Schaltungsanordnung zur Vorortung hochohmiger und intermittierender Kabelfehler unter Anwendung der Impuls-Echo-Methode, wobei als erste Spannungsquelle (U₀) zur Zündung des Kabelfehlers eine Hochspannungsquelle vorgesehen ist und zusätzlich eine weitere Spannungsquelle (U₁) an das zu prüfende Kabel angeschlossen ist, welche nach der Zündung des Fehlers den entstandenen Lichtbogen für die Zeit der Impuls-Echo-Messung stabil aufrechterhält, **dadurch gekennzeichnet,** daß in Serie zur ersten Spannungsquelle (U₀) ein Ladungswiderstand (R₀) und eine Luftfunkenstrecke geschaltet sind sowie, daß der Serienschaltung aus der ersten Spannungsquelle (U₀) und dem Ladungswiderstand (R₀) eine Ladekapazität (C₀) parallelgeschaltet ist, so daß ein Stoßwellengenerator ausgebildet wird, der über eine niederohmige Impedanz (R₂) und ein zu dieser in Serie geschaltetes, nichtlineares Bauteil (N₁) an das zu prüfende Kabel angeschlossen ist, wobei das nichtlineare Bauteil (N₁) zum Zeitpunkt der Zündung auf Durchlaß gesteuert ist, so daß die Stoßwelle auf das zu prüfende Kabel gelangt, während es einige Mikrosekunden später sperrt, so daß die Meßimpulse des Impuls-Echo-Meßgerätes vom Stoßwellengenerator entkoppelt werden.

2. Schaltungsanordnung nach Anspruch 1, **dadurch gekennzeichnet,** daß die Meßimpulse und die Zündspannung des Stoßwellengenerators durch die Serienschaltung einer Induktivität (L) und einer Diode (D) von der weiteren Spannungsquelle (U₁) entkoppelt sind.

3. Schaltungsanordnung nach Anspruch 1, **dadurch gekennzeichnet,** daß als Nichtlinearität (N₁) ein Varistor vorgesehen ist.

4. Schaltungsanordnung nach Anspruch 1, **dadurch gekennzeichnet,** daß als Nichtlinearität (N₁) eine Luftfunkenstrecke vorgesehen ist.

5. Schaltungsanordnung nach Anspruch 1, **dadurch gekennzeichnet,** daß als Nichtlinearität (N₁) eine Gasfunkenstrecke vorgesehen ist.

6. Schaltungsanordnung nach Anspruch 1, **dadurch gekennzeichnet,** daß als Nichtlinearität (N₁) eine Induktivität vorgesehen ist, die sich während der Stoßspitze im Sättigungsbereich befindet.

7. Schaltungsanordnung nach Anspruch 1, **dadurch gekennzeichnet,** daß als Nichtlinearität (N₁) die Primär- und Sekundärwicklung eines Transformators in den Ankopplungskreis zum Stoßwellengenerator eingeschaltet ist, wobei über die jeweils andere Wicklung der Sättigungszustand des Transformators gesteuert wird.

8. Schaltungsanordnung nach Anspruch 1, **dadurch gekennzeichnet,** daß als Nichtlinearität (N₁) ein Kaltleiter vorgesehen ist.

9. Schaltungsanordnung nach Anspruch 1, **dadurch gekennzeichnet,** daß als Nichtlinearität (N₁) eine oder mehrere Glühlampen eingesetzt ist/sind.

10. Schaltungsanordnung nach Anspruch 1, **dadurch gekennzeichnet,** daß als Nichtlinearität (N₁) ein konventioneller Überspannungsableiter eingesetzt ist.

11. Schaltungsanordnung nach Anspruch 1, **dadurch gekennzeichnet**, daß zur Simulation der Nichtlinearität (N₁) gesteuerte oder geregelte, zeitvariante, lineare Elemente vorgesehen sind.

12. Schaltungsanordnung nach Anspruch 2, **dadurch gekennzeichnet,** daß in den Ankopplungszweig der weiteren Spannungsquelle (U₁) ein weiterer Widerstand (R₃) eingefügt ist, wobei in Verbindung mit einer Ladekapazität (C₁), die der Serienschaltung aus der weiteren Spannungsquelle (U₁) und dem weiteren Widerstand (R₃) parallelgeschaltet ist, die Entkopplungsdiode (D) entfallen kann.

13. Schaltungsanordnung nach Anspruch 12, **dadurch gekennzeichnet,** daß bei entsprechender Dimensionierung des weiteren Widerstands (R₃) die Induktivität (L) entfallen kann.

14. Schaltungsanordnung nach Anspruch 1, **dadurch gekennzeichnet,** daß die niederohmige Impedanz (R₂) aus einem Widerstand (R₄) besteht, welchem eine Serienschaltung eines Widerstandes (R₅) und eines Kondensators (C₂) parallelgeschaltet ist.

15. Schaltungsanordnung nach Anspruch 1, **dadurch gekennzeichnet**, daß die niederohmige Impedanz (R₂) aus einer Parallelschaltung eines Widerstandes (R₆) mit einem Kondensator (C₃) besteht.

## Claims

1. Circuit arrangement for pre-locating high ohmic and intermittent cable faults using the pulse echo method, in which as first voltage source (U₀) for the ignition of the cable fault a high voltage source is provided and additionally a further voltage source (U₁) is connected to the cable which is to be tested, which after the ignition of the fault maintains in a stable manner the arc which has formed for the time of the pulse echo measurement, characterised in that a load resistance (R₀) and an air spark section are connected in series to the first voltage source (U₀), and also that a load capacitance (C₀) is connected in parallel to the series connection from the first voltage source (U₀) and the load resistance (R₀) so that a shock wave generator is constructed, which is connected to the cable to be tested via a low ohmic impedance (R₂) and a nonlinear component (N₁) connected thereto in series, in which the nonlinear component (N₁) at the moment of ignition is controlled to pass, so that the shock wave reaches the cable to be tested, whilst it shuts off a few microseconds later so that the measurement pulses of the pulse echo measurement apparatus are uncoupled from the shock wave generator.

2. Circuit arrangement according to Claim 1, characterised in that the measurement pulses and the ignition voltage of the shock wave generator are uncoupled from the further voltage source (U₁) by the series connection of an inductance (L) and of a diode (D).

3. Circuit arrangement according to Claim 1, characterised in that a varistor is provided as non-linearity (N₁).

4. Circuit arrangement according to Claim 1, characterised in that an air spark section is provided as non-linearity (N₁).

5. Circuit arrangement according to Claim 1, characterised in that a gas spark section is provided as non-linearity (N₁).

6. Circuit arrangement according to Claim 1, characterised in that as non-linearity (N₁) an inductance is provided which is situated during the surge peak in the saturation range.

7. Circuit arrangement according to Claim 1, characterised in that as non-linearity (N₁) the primary and secondary winding of a transformer is connected into the coupling circuit to the shock wave generator, in which the saturation status of the transformer is controlled via the respective other winding.

8. Circuit arrangement according to Claim 1, characterised in that a cold conductor is provided as non-linearity (N₁).

9. Circuit arrangement according to Claim 1, characterised in that as non-linearity (N₁) one or more glow lamps is/are used.

10. Circuit arrangement according to Claim 1, characterised in that as non-linearity (N₁) a conventional surge arrester is used.

11. Circuit arrangement according to Claim 1, characterised in that for simulation of the non-linearity (N₁) controlled or regulated, time-variant, linear elements are provided.

12. Circuit arrangement according to Claim 2, characterised in that a further resistance (R₃) is included in the coupling branch of the further voltage source (U₁), in which in connection with a loading capacitance (C₁) which is connected in parallel to the series connection of the further voltage source (U₁) and the further resistance (R₃), the uncoupling diode (D) can be eliminated.

13. Circuit arrangement according to Claim 12, characterised in that with corresponding dimensioning of the further resistance (R₃) the inductance (L) can be eliminated.

14. Circuit arrangement according to Claim 1, characterised in that the low-ohmic impedance (R₂) consists of a resistance (R₄) to which a series connection of a resistance (R₅) and of a capacitor (C₂) is connected in parallel.

15. Circuit arrangement according to Claim 1, characterised in that the low-ohmic impedance (R₂) consists of a parallel circuit of a resistance (R₆) with a capacitor (C₃).

## Revendications

1. Agencement de circuit pour localiser préalablement des défauts de câbles à haute résistance ohmique et intermittents en utilisant la méthode par écho d'impulsion, étant précisé qu'on prévoit comme première source de tension (U₀) pour amorcer le défaut de câble une source haute tension, et qu'une source de tension supplémentaire (U₁) est raccordée au câble à contrôler et, après l'amorçage du défaut, maintient stable pendant la durée de la mesure de l'écho d'impulsion l'arc électrique formé, **caractérisé** en ce qu'une résistance de charge (R₀) et une distance de décharge dans l'air sont branchées en série à la première source de tension (U₀), et en ce qu'une capacité de charge (C₀) est branchée en parallèle au montage en série formé de la première source de tension (U₀) et de la résistance de charge (R₀), ce qui forme un générateur d'ondes de choc qui est relié au câble à contrôler par l'intermédiaire d'une impédance à faible résistance (R₂) et d'un composant non linéaire (N₁) branché en série à celle-ci, étant précisé qu'au moment de l'amorçage, le composant non linéaire (N₁) est commandé en vue d'une transmission de sorte que l'onde de choc arrive sur le câble à contrôler, alors que quelques microsecondes plus tard, il est bloqué de sorte que les impulsions de mesure de l'échomètre à impulsions sont découplées du générateur d'ondes de choc.

2. Agencement de circuit selon la revendication 1, **caractérisé** en ce que les impulsions de mesure et la tension d'amorçage du générateur d'ondes de choc sont découplées de la source de tension supplémentaire (U₁) par le montage en série d'une inductance (L) et d'une diode (D).

3. Agencement de circuit selon la revendication 1, **caractérisé** en ce qu'on prévoit comme composant non linéaire (N₁) un varistor.

4. Agencement de circuit selon la revendication 1, **caractérisé** en ce qu'on prévoit comme composant non linéaire (N₁) une distance de décharge dans l'air.

5. Agencement de circuit selon la revendication 1, **caractérisé** en ce qu'on prévoit comme composant non linéaire (N₁) une distance de décharge dans un gaz.

6. Agencement de circuit selon la revendication 1, **caractérisé** en ce qu'on prévoit comme composant non linéaire (N₁) une inductance qui se trouve dans la zone de saturation pendant la pointe de choc.

7. Agencement de circuit selon la revendication 1, **caractérisé** en ce que, comme composant non linéaire (N₁), on insère les enroulements primaire et secondaire d'un transformateur dans le circuit de couplage qui mène au générateur d'ondes de choc, l'état de saturation du transformateur étant commandé par l'intermédiaire de l'autre enroulement.

8. Agencement de circuit selon la revendication 1, **caractérisé** en ce qu'on prévoit comme composant non linéaire (N₁) une thermistance CTP.

9. Agencement de circuit selon la revendication 1, **caractérisé** en ce qu'on utilise comme composant non linéaire (N₁) une ou plusieurs lampes à incandescence.

10. Agencement de circuit selon la revendication 1, **caractérisé** en ce qu'on utilise comme composant non linéaire (N₁) un coupe-circuit de surtension classique.

11. Agencement de circuit selon la revendication 1, **caractérisé** en ce qu'on prévoit, pour simuler le composant non linéaire (N₁), des éléments linéaires commandés ou réglés et variables dans le temps.

12. Agencement de circuit selon la revendication 12, **caractérisé** en ce qu'on insère dans le branchement de couplage de la source de tension supplémentaire (U₁) une résistance supplémentaire (R₃), étant précisé qu'en liaison avec une capacité de charge (C₁) qui est branchée en parallèle au montage en série formé de la source de tension supplémentaire (U₁) et de la résistance supplémentaire (R₃), on peut supprimer la diode de découplage (D).

13. Agencement de circuit selon la revendication 12, **caractérisé** en ce que, avec un dimensionnement approprié de la résistance supplémentaire (R₃), l'inductance (L) peut être supprimée.

14. Agencement de circuit selon la revendication 1, **caractérisé** en ce que l'impédance à faible résistance (R₂) se compose d'une résistance (R₄) à laquelle est branché en parallèle un montage en série d'une résistance (R₅) et d'un condensateur (C₂).

15. Agencement de circuit selon la revendication 1, **caractérisé** en ce que l'impédance à faible résistance (R₂) se compose d'un montage parallèle d'une résistance (R₆) avec un condensateur (C₃).
